# EUROPEAN PATENT SPECIFICATION

(11) **EP 3 886 541 B1**
(45) Date of publication and mention of the grant of the patent: **18.02.2026**
(21) Application number: 20165903.4
(22) Date of filing: 26.03.2020
(51) Int. Cl.: H05K 1/02, H05K 3/46

(54) **ALIGNMENT WITH LIMITED NON-LINEAR DEFORMATION COMPENSATION OF COMPONENT CARRIER STRUCTURE**
AUSRICHTUNG MIT BEGRENZTER NICHTLINEARER VERFORMUNGSKOMPENSATION DER KOMPONENTENTRÄGERSTRUKTUR
ALIGNEMENT AYANT UNE COMPENSATION DE DÉFORMATION NON LINÉAIRE LIMITÉE DE LA STRUCTURE DE SUPPORT DE COMPOSANT

(43) Date of publication of application: 29.09.2021
(73) Proprietor: AT & S Austria Technologie & Systemtechnik Aktiengesellschaft, 8700 Leoben-Hinterberg (AT)
(72) Inventor: Ifis, Abderrazzaq, 8700 Leoben (AT)
(74) Representative: Donatello, Daniele

(56) References cited:
- WO-A1-2014/027484
- US-A- 6 165 658
- US-A1- 2002 118 350

## Description

The invention relates to a method of aligning a component carrier structure, a computer-readable medium, and a program element.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

Moreover, proper alignment of a component carrier or a preform thereof is an issue during manufacture.

Document WO 2014/027484 A1 discloses a method of aligning a substrate through the correction of the deviation of the reference marks predefining a maximum allowed non-linear compensation limit, determining the actual non-linear deformation of the substrate and compensating the actual non-linear deformation, averaging out the compensation by averaging out the distortion acquired from two alignment markers.

Documents US 2002/118350 A1 and US 6 165 658 A each discloses a method of aligning a substrate, determining the an actual non-linear deformation of the substrate to be aligned, and providing a non-linear deformation compensation within certain limits.

It is an object of the invention to enable processing of a component carrier structure with high spatial accuracy.

In order to achieve the object defined above, a method of aligning a component carrier structure, a computer-readable medium, and a program element according to the independent claims are provided.

According to an embodiment of the invention, a method according to the independent claim 1 is provided.

According to another embodiment of the invention, a program element (for instance a software routine, in source code or in executable code) is provided, which, when being executed by a processor (such as a microprocessor or a CPU), is adapted to control or carry out a method having the above mentioned features.

According to yet another embodiment of the invention, a computer-readable medium (for instance a CD, a DVD, a USB stick, a floppy disk or a hard disk) is provided, in which a computer program is stored which, when being executed by a processor (such as a microprocessor or a CPU), is adapted to control or carry out a method having the above mentioned features.

Data processing which may be performed according to embodiments of the invention can be realized by a computer program, that is by software, or by using one or more special electronic optimization circuits, that is in hardware, or in hybrid form, that is by means of software components and hardware components.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "component carrier structure" may particularly denote either a component carrier (such as a printed circuit board or an IC substrate) itself or a larger body (such as a panel or an array) of multiple component carriers or pre-forms thereof (for instance a semifinished product obtained during manufacturing component carriers individually or in a batch process).

In the context of the present application, the term "layer structure" may particularly denote a continuous layer, a patterned layer or a plurality of non-consecutive islands within a common plane. A layer structure may be electrically insulating and/or electrically conductive.

In the context of the present application, the term "maximum allowed non-linear compensation limit" may particularly denote one or more parameters being indicative of a maximum admissible amount of compensation of non-linear deformation of a component carrier structure during alignment. Hence, said maximum allowed non-linear compensation limit defines an upper limit of compensating non-linear deformation, which limit may not be exceeded during non-linear compensation, even if a larger non-linear compensation might be desired in view of an actual non-linear deformation of the component carrier structure. Thus, the maximum allowed non-linear deformation limit may define an upper constraint for non-linear deformation compensation.

In the context of the present application, the term "linear compensation" may particularly denote a procedure of compensating a deformation of a component carrier structure (in particular a panel), which deformation is compensable by a linear shift, a rotation and/or an expansion or a shrinkage in one or two spatial dimensions of the component carrier structure. For instance, such a linear compensation may involve an approximation of an actually detected shape of the component carrier structure by a rectangle or a parallelogram.

In the context of the present application, the term "non-linear compensation" may particularly denote a procedure of compensating a deformation of a component carrier structure (in particular a panel), which deformation is more complex than a deformation being compensable by a linear shift, a rotation and/or an expansion or a shrinkage in one or two spatial dimensions of the component carrier structure. For instance, such a non-linear compensation may involve an approximation of an actually detected shape of the component carrier structure by a trapezoidal shape (in particular the shape of an irregular trapezoid) or a polygonal shape (in particular the shape of an irregular polygon) with at least five corners.

Correspondingly, the term "non-linear deformation" may particularly denote a deformation of a component carrier structure being more complex than a deformation which is compensable by a linear shift, a rotation and/or an expansion or a shrinkage in one or two spatial dimensions of the component carrier structure. Accordingly, the term "linear deformation" may particularly denote a deformation of a component carrier structure being compensable by a linear shift, a rotation and/or an expansion or a shrinkage in one or two spatial dimensions of the component carrier structure.

According to an exemplary embodiment of the invention, a maximum allowed non-linear compensation limit (which may also be denoted as flexible correction value for non-linear distortions compensation) indicating an upper limit of an allowable non-linear compensation during alignment of the component carrier structure may be predefined. Such a predefinition may be made for instance by a user or a machine. This may make it possible to use non-linear scaling without undesired impact on an assembly process. While an unlimited non-linear compensation may be desired when considering accuracy of alignment in isolation, an excessive non-linear compensation may be incompatible with assembly related constraints during processing of the component carrier structure. Thus, the described concept of predefining a maximum allowed non-linear compensation limit may allow obtaining a flexible scaling to improve or even optimize the registration chain without an undesired impact on the performance of the manufacture of component carriers, in particular outer layer performance. In other words, an exemplary embodiment of the invention makes it possible to introduce a non-linear scaling with the possibility to limit the distortions, thereby enabling new capabilities in terms of alignment registration for advanced applications such as high quality component carriers. By introducing a limitation of compensating non-linear distortion, a non-linear scaling may be implemented to fit partially the geometry of the component carrier structure. Indeed, full compensation of the non-linear distortion may be undesired, as various component carrier manufacturing procedures (such as solder printing methods) might not follow in case of unlimited compensation of non-linear distortion. In order to avoid this, an exemplary embodiment of the invention implements a compromise between non-linear scaling and linear scaling by allowing compensation of non-linear distortion at a certain limit only, that may for instance be specified by a user or a machine coordinating manufacture of the component carriers.

According to a possible result of the of the invention, a component carrier with staggered (i.e. laterally and vertically slightly displaced) vertical through connections is provided. Descriptively speaking, centers of gravity of the various vertical through connections may be located for example on (or substantially on) a straight line being slanted with regard to a stacking direction of the layer structures of the component carrier (the stacking direction may hence be perpendicular to the main surfaces of the layer structures). In case of an unlimited non-linear deformation compensation, said vertical through connections would be perfectly aligned above each other without mutual lateral displacement. However, when involving a constraint in terms of a maximum allowed non-linear compensation limit according to an exemplary embodiment of the invention, said vertical through connections may show a slight mutual horizontal displacement resulting in said staggered array.

In the following, further exemplary embodiments of the method, the component carrier, the computer-readable medium, and the program element will be explained.

According to the invention, the method comprises, if the amount of non-linear compensation needed for fully compensating the actual non-linear deformation of the component carrier structure is smaller than the predefined non-linear compensation limit, carrying out full non-linear deformation compensation. In this scenario, carrying out the complete non-linear compensation does not violate the constraint involved by the maximum allowed non-linear compensation limit. Thus, full non-linear compensation can be executed in this scenario without undesired effects on the component carrier manufacturing procedure.

In an embodiment, the non-linear deformation compensation comprises trapezoidal-based compensation or compensation based on a polygon having at least four (or even at least five) corners. In terms of trapezoidal-based compensation, the position of four corners (also defining the length of the various sides and the angles) of the trapezoidal structure may be adjusted for approximating an actual component carrier structure shape. However, a constraint of such an approximation is the boundary condition that the maximum allowed non-linear compensation limit may not be exceeded (at least at outer layers).

In an embodiment, the method comprises, if the actual non-linear deformation is zero (i.e. the deformation is linear), carrying out linear deformation compensation, in particular rectangular-based or parallelogram-based deformation compensation. Thus, if the determination yields the result that the deformation of the component carrier structure is linear and can be modelled by a mere shift, rotation and/or scaling using a parallelogram, in particular a rectangle, no non-linear deformation compensation needs to be carried out at all. Carrying out linear deformation compensation in such an event may keep the computational burden small.

In an embodiment, the non-linear deformation compensation in inner layers of the component carrier structure may exceed the predefined non-linear compensation limit, but non-linear deformation compensation in exterior (in particular surface) layers of the component carrier structure must not exceed the predefined non-linear compensation limit. According to such a preferred embodiment, constraints of the component carrier manufacturing procedure (for instance in terms of assembly) requiring a limitation of the non-linear compensation to the maximum allowed non-linear compensation limit needs to be respected only for the outer layer structures of the component carrier structure which are relevant for such an assembly. However, by allowing even larger non-linear compensation in inner layers of the component carrier structure, no violation of design rules during build-up and assembly of the component carrier structure occurs. Therefore, the freedom of carrying out even very large (in particular unlimited) non-linear compensation in inner layers while respecting the maximum allowed non-linear compensation limit for exterior layers may be further increased and the alignment accuracy may be further improved. Allowing such high tolerances on the inner layers may bring the outer layer to zero or minimized non-linear deformation.

According to the invention, the method comprises predefining the maximum allowed non-linear compensation limit for an inner layer of the component carrier structure larger than another smaller maximum allowed non-linear compensation limit for an exterior (for instance surface) layer of the component carrier structure. In a further refined embodiment, the maximum allowed non-linear compensation limit may thus be decreased (for instance continuously, gradually or stepwise) from a largest value at a center of the component carrier structure up to a lowest value at a respective exterior main surface. In other words, the constraint involved by said non-linear compensation limits may be relaxed in an interior of the component carrier structure and may be made stricter at its outer layers. This may ensure proper alignment without compromising on further manufacturing processes.

In an embodiment, the non-linear compensation limit is defined by a machine or by a user. Thus, the maximum non-linear compensation limit is fixed and may not be exceeded for a certain manufacturing task, but can nevertheless be freely and flexibly defined in advance. This provides high flexibility while simultaneously guaranteeing compliance with manufacturing process related constraints.

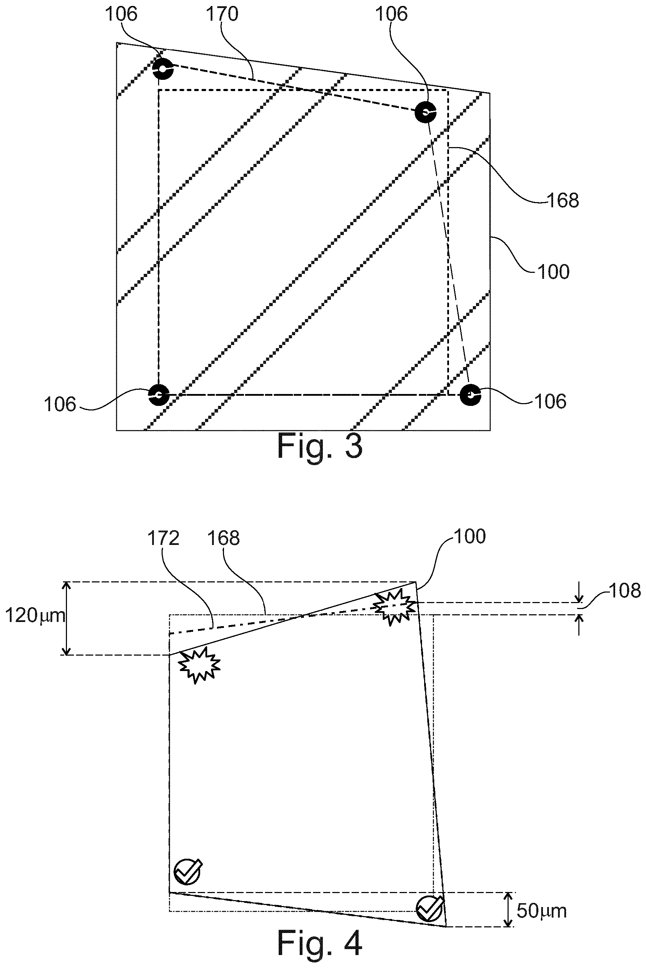

In an embodiment, the non-linear compensation limit is an absolute value of non-linear deformation compensation, for instance 100 µm. A corresponding example is shown in Figure 4. Additionally or alternatively, the non-linear compensation limit may be a ratio between a maximum allowed non-linear deformation compensation and an actual non-linear deformation, for instance a percentage such as 50%. This may render a non-linear compensation limit independent from absolute values which may be more appropriate for covering component carrier structures of different dimensions or scales.

In an embodiment, the method comprises predefining the non-linear compensation limit as a ratio between absolute values of a maximum allowed non-linear deformation compensation and an actual non-linear deformation. For instance, said ratio may be in a range from 0% to 100%, in particular may be in a range between 20% and 70%. For example, it is possible to make 100% alignment on an inner layer, to gradually go down to 95%, etc., down until 0% on an outer layer.

In an embodiment, the ratio is higher at an inner layer than at an outer layer of the component carrier structure, in particular may be decreased continuously from an innermost layer to an outermost layer of the component carrier structure. For example, it is possible to have a range of 0% (rectangular) to 100% (fully non-linear) in one layer stack, which may be used as a design parameter to be adjusted in accordance with design rules.

According to the invention, the actual non-linear deformation is determined based on the detection of one or more alignment markers of the component carrier structure. In the context of the present application, the term "alignment marker" may particularly denote a structural or physical feature of a component carrier structure which can be detected, optically inspected or seen visually on a surface, in a surface region or in an interior of the component carrier structure (in particular a preform of a component carrier such as a printed circuit board). Alignment markers may be used as a basis for an alignment to be carried out in terms of processing the component carrier structure, in particular by a processing machine which can use alignment marker for spatial orientation. For instance, such an alignment marker may be a through hole or a blind hole or a pad on and/or in the component carrier structure which can be optically inspected so as to determine position and/or orientation of the component carrier structure, such as a preform of the component carrier (for instance a panel). For example, a number of such holes and pads may be provided as alignment markers in edge regions of a rectangular component carrier structure such as a panel. One or both opposing main surfaces and/or an interior of the component carrier structure may be provided with alignment markers. For instance, such alignment markers may be captured by an optical detector. Different types of alignment markers may be used for that purpose, such as skiving marks, corners (for instance of a rectangular electric device), and laser targets. This may further refine the alignment accuracy. Generally, the alignment markers may be any fiducials, i.e. any objects placed in the field of view of an imaging system which appear in the image produced, for use as a point of reference or a measure. It may be something placed into or on an imaging subject. Such alignment markers may be used as well for adjusting a processing device relative to the component carrier structure to be processed.

In an embodiment, the method comprises aligning and processing the component carrier structure based on determined alignment information. Said alignment information may be derived from a result of the deformation compensation. Correspondingly, the apparatus may comprise a processing unit configured for processing the component carrier structure based on the determined alignment information. In other words, detecting the alignment markers may allow determining positional information concerning the component carrier structure. This information, which can be denoted as alignment information, can then be used for correspondingly adjusting a subsequent processing of the component carrier structure, for instance the formation of electrically conductive tracks within a horizontal plane of the component carrier structure and/or the formation of vertical electrically conductive through-connections, for instance formed by a combination of copper foil lamination, copper foil patterning, formation of vias and filling the vias with electrically conductive material, for instance by plating.

In an embodiment, the method comprises partitioning the component carrier structure into a plurality of partitions (for instance quarters or other rectangular regions of the component carrier structure in a plan view), and carrying out the aligning individually for the partitions. Hence, the method can also be executed in terms of partition alignment. While it is possible in an embodiment to align the entire component carrier structure as a whole, i.e. with one partition only (which may be denoted as global alignment), another embodiment may, however, align for the scenario of partition alignment, where the component carrier structure may be considered to be constituted by at least two partitions. For instance, the various partitions may be quarter panels of a panel-type component carrier structure. For partitioning, the component carrier structure may be separated virtually into a plurality of partitions (for example into four partitions) by determining at least one partition line, in particular at least two orthogonal partition lines, wherein the at least one partition line may be determined so as to run outside of active regions of the component carrier structure. By preventing that partition lines run through functionally active regions of the component carrier structure (such as a PCB array on a panel), the functionality of functionally active regions of the component carrier structure remains undisturbed by the alignment process.

In an embodiment, the method comprises selecting a local portion of the component carrier structure, and carrying out the aligning only for the local portion. Thus, the method can also be carried out in terms of local alignment. In other words, the above-described process of aligning may be limited only to a specific local portion of the component carrier structure and is then not carried out other regions thereof.

In an embodiment, processing the component carrier structure comprises at least one of the group consisting of imaging (in particular photoimaging), solder mask treatment, screen printing, and mechanically treating (in particular in an assembly process) the component carrier structure. These and other procedures require a precise alignment of the component carrier structure to be processed. In particular, the described alignment concept may be advantageously applied to embedding, for assembly processes, for die bonding and/or for laser processing.

In an embodiment, the staggered vertical interconnect structures of the component carrier are vias, in particular laser vias, filled with electrically conductive material, in particular copper.

In an embodiment, the component carrier structure is selected from a group consisting of a panel for manufacturing component carriers, an array of multiple component carriers or preforms thereof, and a component carrier for carrying at least one component. In a preferred embodiment, a PCB panel may be treated with the described alignment concept.

In an embodiment, an aligning apparatus comprises an alignment marker formation unit configured for forming alignment markers on and/or in the component carrier structure. For instance, formation of pad-type alignment markers may be carried out by connecting an electrically conductive layer (for instance laminating a copper foil or plating a copper layer) on a stack of component carrier structure material, in particular on an electrically insulating layer structure such as a prepreg layer. Thereafter, the electrically conductive layer may be patterned to thereby form the one or more pad-type alignment markers.

In an embodiment, the method is carried out using a laser direct imaging (LDI) device. For instance, the LDI device may form or may form part of the alignment marker formation unit. At least one of the alignment markers may be formed involving patterning an electrically conductive layer structure. For instance, this may be accomplished preferably by laser direct imaging (LDI), or alternatively by photoimaging. LDI may use a component carrier structure with a photosensitive surface, positioned under a controllable laser. A control unit scans the component carrier structure into a raster image. Matching the raster image to a predefined metallic pattern corresponding to a respective alignment marker of the component carrier structure allows operating the laser to directly generate the image on said component carrier structure. Advantageously, a highly accurate alignment marker may be formed by LDI even in an environment with harsh conditions.

In an embodiment, the component carrier structure and/or the component carrier comprises a stack of at least one electrically insulating layer structure and at least one electrically conductive layer structure. For example, the component carrier structure and/or the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the component carrier structure and/or the component carrier is shaped as a plate. This contributes to the compact design, wherein the component carrier structure and/or the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier structure and/or the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through holes through the laminate, for instance by laser drilling or mechanical drilling, and by filling them with electrically conductive material (in particular copper), thereby forming vias as through hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) or a photoimageable or dry-etchable organic material like epoxy-based build-up material (such as epoxy-based build-up film) or polymer compounds like polyimide, polybenzoxazole, or benzocyclobutene-functionalized polymers.

In an embodiment, the at least one electrically insulating layer structure comprises at least one of the group consisting of resin (such as reinforced or non-reinforced resins, for instance epoxy resin or bismaleimide-triazine resin), cyanate ester resin, polyphenylene derivate, glass (in particular glass fibers, multi-layer glass, glass-like materials), prepreg material (such as FR-4 or FR-5), polyimide, polyamide, liquid crystal polymer (LCP), epoxy-based build-up film, polytetrafluoroethylene (PTFE, Teflon), a ceramic, and a metal oxide. Reinforcing structures such as webs, fibers or spheres, for example made of glass (multilayer glass) may be used as well. Although prepreg particularly FR4 are usually preferred for rigid PCBs, other materials in particular epoxy-based build-up film or photoimageable dielectric material may be used as well. For high frequency applications, high-frequency materials such as polytetrafluoroethylene, liquid crystal polymer and/or cyanate ester resins, low temperature cofired ceramics (LTCC) or other low, very low or ultra-low DK materials may be implemented in the component carrier as electrically insulating layer structure.

In an embodiment, the at least one electrically conductive layer structures comprises at least one of the group consisting of copper, aluminum, nickel, silver, gold, palladium, and tungsten. Although copper is usually preferred, other materials or coated versions thereof are possible as well, in particular coated with supra-conductive material such as graphene.

At least one component, which can be embedded in the stack, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an optical element (for instance a lens), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a substrate, an interposer or a further component carrier, for example in a board-in-board configuration. The component may be surface mounted on the component carrier and/or may be embedded in an interior thereof. Moreover, also other components, may be used as component.

In an embodiment, the component carrier structure and/or the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier structure in terms of surface treatment. For instance, it is possible to form such as solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), gold (in particular Hard Gold), chemical tin, nickel-gold, nickel-palladium, Electroless Nickel Immersion Palladium Immersion Gold (ENIPIG), etc.

The aspects defined above and further aspects of the invention are apparent from the examples of embodiment to be described hereinafter and are explained with reference to these examples of embodiment.
Figure 1 illustrates linear deformation compensation on panel level based on a rectangular model.
Figure 2 illustrates linear deformation compensation on panel level based on a parallelogram model.
Figure 3 illustrates non-linear deformation compensation on panel level based on a trapezoidal model.
Figure 4 illustrates limited non-linear deformation compensation according to an exemplary embodiment of the invention.
Figure 5 to Figure 7 illustrate non-linear compensation involving a predefined limit according to an exemplary embodiment of the invention.
Figure 8 shows an apparatus for aligning a panel type component carrier structure according to an exemplary embodiment of the invention.
Figure 9 is a block diagram illustrating a method of aligning a component carrier structure according to an exemplary embodiment of the invention.
Figure 10 shows a component carrier manufactured according to an exemplary embodiment of the invention using an alignment method described referring to Figure 9.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, a maximum allowed non-linear compensation limit, which may also be denoted as a flexible correction value, may be predefined for non-linear distortions compensation of a component carrier structure such as a panel used for manufacturing multiple component carriers (in particular printed circuit boards, PCP).

A gist of an exemplary embodiment of the invention is to find a compromise between non-linear compensation and dimensional stability in case of high panel deformation. Indeed, when aligning a panel, subpanel or a component carrier, several alignment modes could be set up but each of them has its own limitations.

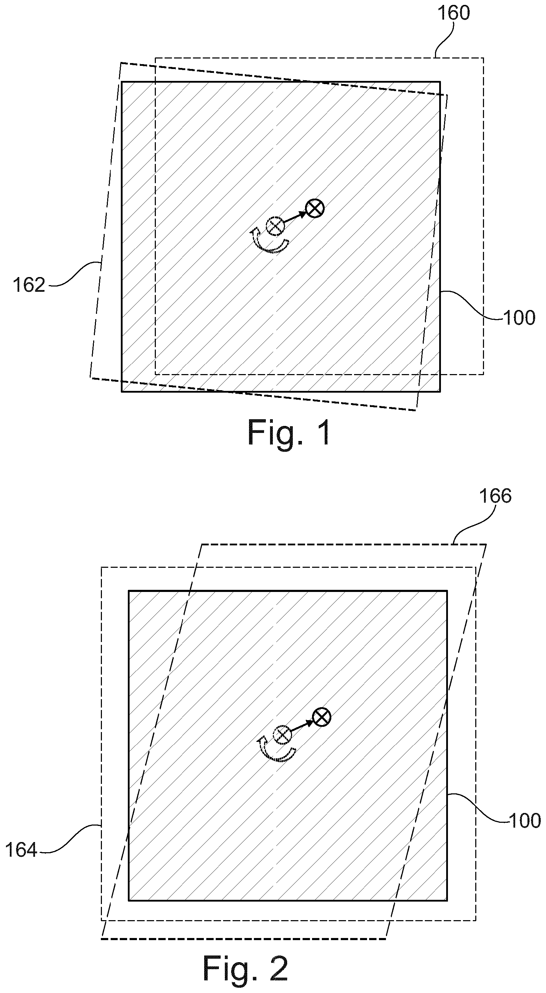

For example, using a rectangular alignment (compare Figure 1) allows a very stable performance of pad-to-pad distance, scale values and easy assembly for a user. If pad-to-pad distance is stable, then scale values (stretch factors in x and y) are also stable. However, a rectangular alignment does not allow the compensation of non-linear deformations and therefore higher mis-registration, in particular to inner layers.

On the other hand, using trapezoid alignment (compare Figure 3) as such may allow the compensation of non-linear distortion but may also induce a non-stable dimensional performance where the pad-to-pad distance and scale values will have a high variation. As a result, the assembly may become very critical on a user side.

There is a third mode involving linear compensation based on a parallelogram as an approximation of the component carrier structure (compare Figure 2). This scaling method may provide stable scale values and pad-to-pad performance. However, even parallelogram based linear approximation does not compensate non-linear errors, as the parallelogram edges have the constraint to be parallel.

Exemplary embodiments of the invention may overcome at least part of the above-described shortcomings and may provide a more advanced scaling mode that finds a proper compromise between non-linear distortion and the dimensional stability of the final layers. In order to achieve this, a compensation method can be carried out which allows a non-linear compensation (in particular a trapezoid compensation), however only at certain extent or limit, which may not be exceeded. A corresponding maximum allowed non-linear compensation limit may be defined for instance according to a pad-to-pad tolerance and/or a number of the layers of a component carrier structure or a component carrier (such as a PCB) derived therefrom. In other words, an exemplary embodiment of the invention allows a trapezoid compensation at certain limit, as shown in Figure 4 to Figure 7 described below.

In this context, a set of at least one value and/or at least one percentage or ratio may be flexible and may depend, for example, on the desired pad-to-pad performance and also the number of layers. Furthermore, it may be possible to relax the limitation of the first inner layers while the limitation gets tighter gradually up to the outer layer. In this case, the higher the layer count, the easier may be the application of the method. Descriptively speaking, the more layers, the easier to compensate. It may be advantageous to be very accurate on an outer layer (and it may be possible to make adjustment gradually, especially in case of multiple layers). This may hold in particular in the case where very relaxed specifications are present for laser processing, but tightened specifications need to be considered for photo processing. The value of said limit can be determined in accordance with a respective design and material of a component carrier to be manufactured to define a most proper value.

Also to ensure a high registration performance to the inner layers, a compromise between drilling process and imaging may be set according to an exemplary embodiment of the invention. Advantageously, the drilling process can have higher limitation while the imaging process can have a tightened limit according a remaining annular ring.

A method according to an exemplary embodiment of the invention may hence allow a compromise between compensation of non-linear distortions and dimensional stability by setting or predefining a flexible value of a maximum allowed non-linear compensation limit that allows proper alignment (in particular alignment optimization) for each different design and specification. By exemplary embodiments, a higher registration capability may be combined with lower scrap. It may also become possible to manufacture small features and increase the interconnection density.

**Figure 1** illustrates linear deformation compensation on panel level based on a rectangular model. **Figure 2** illustrates linear deformation compensation on panel level based on a parallelogram model.

On panel level, it may be distinguished between linear and non-linear deformation. The linear deformation can be covered by linear scaling (using a rectangular approach as in Figure 1 or a parallelogram approach as in Figure 2) to cover shift, rotation, and expansion/shrinkage in both orthogonal horizontal directions of the paper plane of Figure 1 and Figure 2. More specifically, Figure 1 shows the actual shape of a component carrier structure 100, such as a panel for manufacturing PCBs. As illustrated by reference numeral 160, linear compensation using a rectangle approximating the actual shape of the component carrier structure 100 may involve a center shift. As illustrated by reference numeral 162, linear compensation using a rectangle approximating the actual shape of the component carrier structure 100 may also involve a rotation of the rectangle. Descriptively speaking, a search may be carried out for a rectangle providing a best fit (for instance in terms of a least mean squares algorithm) with the actual shape of the component carrier structure 100.

As illustrated by reference numeral 164 in Figure 2, linear compensation using a rectangle approximating the actual shape of the component carrier structure 100 may also involve a scaling (i.e. an expansion or a shrinkage) of the rectangle.

As illustrated by reference numeral 166 in Figure 2, linear compensation may also use a parallelogram approximating the actual shape of the component carrier structure 100.

However, the rectangular based or parallelogram based distortion compensation only works properly for relatively small and simple distortions. More complex deformation shapes of the component carrier structure 100 cannot be properly approximated by linear compensation only, i.e. neither by a rectangle nor by a parallelogram approach.

**Figure 3** illustrates non-linear deformation compensation on panel level based on a trapezoidal model. Figure 3 illustrates a more complex non-linear deformation of component carrier structure 100, as indicated by the positions of various alignment markers 106 of component carrier structure 100. As illustrated by reference numeral 168, this non-linear deformation cannot be approximated properly by a rectangle.

In principle, also local alignment is an option. For high mis-registration, local alignment may also be inappropriate to properly cover the deformation when it keeps using linear scaling.

However, as indicated by reference numeral 170, a trapezoidal shape may be appropriate for reflecting even more complex non-linear deformation of component carrier structure 100. Hence, when a component carrier structure 100 such as a panel deforms in trapezoid shape or more complex geometries, trapezoid scaling can be used.

However, trapezoid alignment may induce scale values variation, pad-to-pad deviation and hole to hole deviation. Thus, trapezoidal alignment may not be allowed by users in certain scenarios, as it may highly impact assembly of a readily manufactured component carrier. Hence, unlimited trapezoidal distortion compensation may compromise the user's freedom to further process component carrier structure 100 properly during a component carrier manufacturing process.

**Figure 4** illustrates non-linear deformation compensation with a predefined limitation of a maximum admissible non-linear deformation compensation according to an exemplary embodiment of the invention.

Basically, the non-linear compensation scheme of Figure 4 may correspond to the one of Figure 3. However, according to the exemplary embodiment of the invention of Figure 4, a predefined maximum allowed non-linear compensation limit 108 may be defined for limiting the amount of non-linear deformation compensation. Descriptively speaking, the predefined maximum allowed non-linear compensation limit 108 may be a flexibly definable correction value for non-linear distortions compensation which may not be exceeded in order to maintain compliance with boundary conditions, for instance related to assembly.

Also in Figure 4, reference numeral 100 shows a component carrier structure (such as a PCB panel) being presently processed. A best fitting rectangle, as indicated by reference numeral 168, is incapable of properly approximating the actual shape of the non-linearly deformed component carrier structure 100. A trapezoid completely corresponding to the trapezoidal shape of component carrier structure 100 would require a relatively large non-linear compensation, as indicated in Figure 4, which however might be inappropriate in terms of assembly constraints. Therefore, an exemplary embodiment of the invention limits the allowable maximum non-linear compensation limit 108 to a value of for example 30 µm. Such a flex limit or maximum allowed non-linear compensation limit 108 may be defined as taking into account an annular ring and pad-to-pad and/or hole-to-hole tolerances. For instance, value 108 may be an output of a Computer-aided manufacturing (CAM) program. It is however also possible that a user defines the maximum allowed non-linear compensation limit 108.

Thus, since the actually appropriate value of non-linear deformation compensation would be higher, an exemplary embodiment of the invention nevertheless limits non-linear deformation compensation to the maximum allowed non-linear compensation limit 108 of for instance 30 µm, to achieve compliance also with requirements of the further manufacturing procedure of the component carrier manufacturing structure 100. A trapezoid in compliance with said limit 108 while at the same time providing an appropriate approximation of the shape of the deformed component carrier structure 100 and thus providing an acceptable degree of non-linear deformation compensation of the non-linearly deformed component carrier structure 100 is indicated in Figure 4 with reference numeral 172.

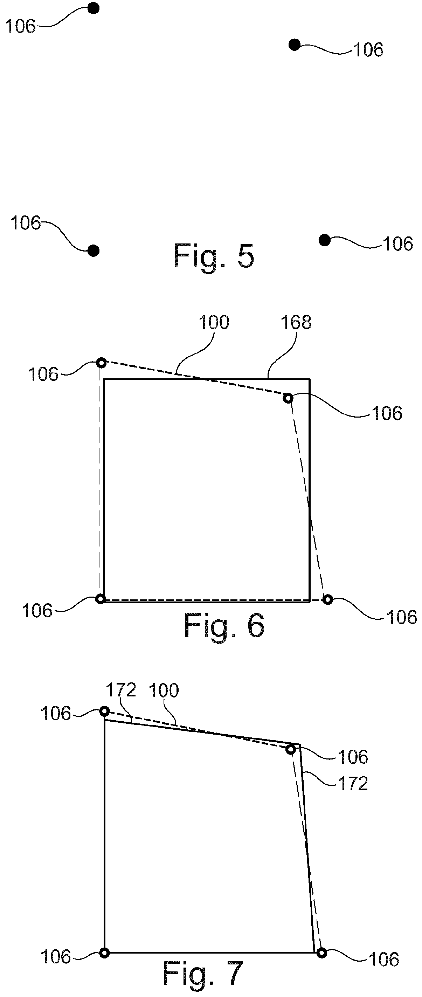

Figure 5 to Figure 7 illustrate non-linear compensation involving a predefined limit 108 according to an exemplary embodiment of the invention.

Referring to **Figure 5****,** an arrangement of alignment markers 106 (for instance having a diameter of 1.3 mm) on a component carrier structure 100 is shown. For instance, the arrangement shown in Figure 5 may be obtained using X-ray drills on a target. No rectangular compensation needs to be carried out.

**Figure 6** relates to a laser process. Drills in accordance with a trapezoidal shape may be carried out for a perfect hit (with or without skiving). Hence, Figure 6 illustrates trapezoidal alignment instead of rectangular alignment.

Referring to **Figure 7****,** an image is shown which relates to trapezoidal compensation with limitation according to an exemplary embodiment of the invention. Hence, only a percentage of the trapezoid can be approximated. The execution of non-linear compensation using a trapezoid respecting limitations prevents higher distortions of the component carrier structure 100 and correspondingly singulated component carriers 100 at a user side. Descriptively speaking, an unlimited non-linear compensation may violate a specification in terms of admissible pad-to-pad distances of component carriers 100. For instance, the limitation (indicated by a maximum allowed non-linear compensation limit 108) may be given depending on an indicator value. If said indicator value is for instance lower than 60 µm, then no limitation is needed. If however the indicator value is higher than 60 µm, compensation of 60 µm plus 20 µm may be allowed (i.e. a threshold layer number minus a current layer number).

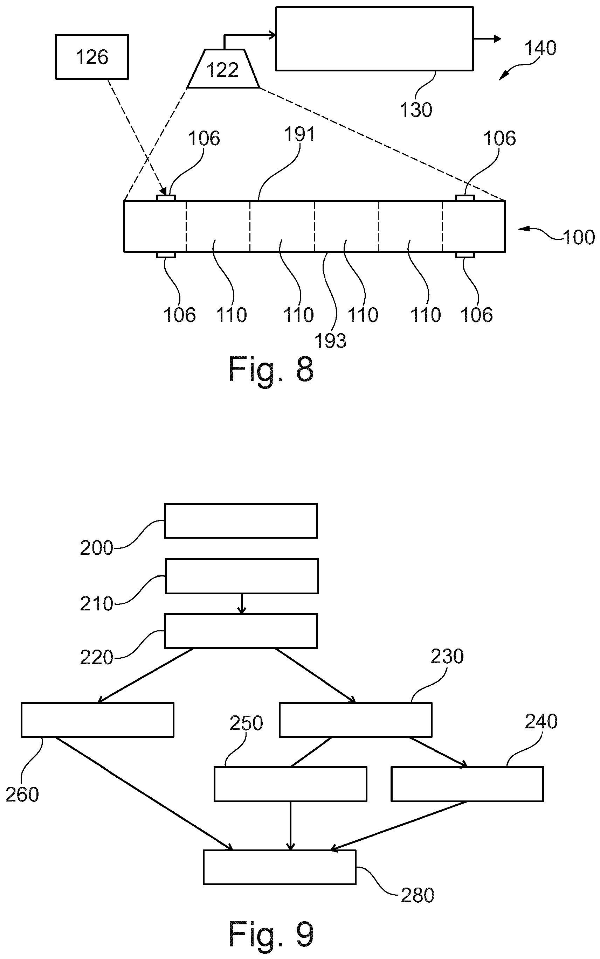

**Figure 8** shows an apparatus 140 for aligning a panel type component carrier structure 100 according to an exemplary embodiment of the invention. The shown component carrier structure 100 comprises a plurality of still integrally connected component carriers 110 (for instance printed circuit boards), or preforms thereof.

The apparatus 140 comprises an alignment marker formation unit 126 being configured for forming alignment markers 106 (for instance pad-type alignment markers) of the component carrier structure 100. For instance, the alignment marker formation unit 126 may comprise a laser direct imaging (LDI) device for forming alignment markers 106 by LDI.

Moreover, the apparatus 140 comprises a detection unit 122 configured for detecting said alignment markers 106 of the component carrier structure 100. For instance, the detection unit 122 may be a camera, such as a CCD camera or a CMOS camera.

A processor 130 may be configured for determining alignment information based on the detected alignment markers 106. In order to identify alignment markers 106 on one or more images captured by the detection unit 122, the processor 130 may be provided with a database including data usable for and processing resources capable of determining pad-type alignment markers 106 in view of their characteristic shape and/or contrast properties. For this purpose, pattern recognition algorithms and/or other image processing algorithms may be implemented in the processor 130 being specifically adapted for the identification of the pad-type alignment markers 106.

Furthermore, the processor 130 is configured for processing the component carrier structure 100 based on determined alignment information. In other words, the processor 130 may control the further manufacture of the component carriers 110 on panel level based on the determined alignment information.

Figure 8 therefore shows how alignment can be carried out during processing component carrier structure 100. In order to accomplish this, the alignment marker formation unit 126 forms the alignment markers 106, as described above. Subsequently, the detection unit 122, which may be a camera, may capture an image of an upper main surface 191 of the component carrier structure 100, or of both opposing main surfaces 191, 193. A corresponding image or corresponding images may be supplied to processor 130 which may determine the position of the alignment markers 106 on the upper main surface 191 and/or on the lower main surface 193 of the component carrier structure 100. This information may be used for subsequent determination of alignment information, i.e. the information concerning positioning and orientation of the component carrier structure 100, for instance with regard to processing equipment of processing the component carrier structure 100. This information may then be used by processor 130 for carrying out the processing (for instance cavity formation, pad formation, patterning, etc.) to be carried out subsequently.

Inter alia, processor 130 may control or carry out a software-based method of aligning component carrier structure 100. An embodiment of such a method will be illustrated in the following referring to Figure 9:
**Figure 9** is a block diagram illustrating a method of aligning a component carrier structure 100 according to an exemplary embodiment of the invention.

As indicated by a block 200, a maximum allowed non-linear compensation limit 108 of compensating non-linear deformation of the component carrier structure 100 during aligning may be defined. For example, this may be done by a user or by the processor 130 of Figure 8 based on data stored in its database. For instance, the value of the limit 108 may be defined so as to comply with a specification of a component carrier 110 to be manufactured. Descriptively speaking, the value of the limit 108 may indicate to which degree an adaptation of a trapezoidal model approximating a non-linear deformed component carrier structure 100 is admissible during a non-linear deformation compensation. However, the degree of adaptation indicated by limit 108 may not be exceeded. In other words, the flex limit 108 may be set in block 200.

Referring to a block 210, it is then possible to measure one or more alignment markers 106 (for instance on an inner layer of a currently processed component carrier structure 100). Such one or more alignment markers 106 (for example one or more alignment holes, inner markers, etc.) may be detected experimentally.

As indicated by a block 220, it is then possible to determine an actual non-linear deformation of the component carrier structure 100 to be aligned. Said actual non-linear deformation can be derived by analyzing the shape of the component carrier structure 100 and/or the arrangement of detected alignment markers 106. In other words, the actual deformation may be determined based on the position of the alignment markers 106. Thus, the actual non-linear deformation can be determined based on the detection of one or more alignment markers 106 of the component carrier structure 100. Descriptively speaking, the non-linear deformation of the component carrier structure 100 can be denoted as a type of deformation which cannot be compensated by a rectangle or a parallelogram (compare Figure 1 and Figure 2).

If the actual non-linear deformation of the component carrier structure 100 is determined to be zero, linear deformation compensation can be carried out in a block 260. Such a linear deformation compensation may be a rectangular-based and/or parallelogram-based deformation compensation, for instance as described above referring to Figure 1 and Figure 2.

If the actual non-linear deformation of the component carrier structure 100 is determined to be non-zero, non-linear deformation compensation can be carried out, see block 230.

More specifically, if an amount of non-linear deformation compensation needed for fully compensating the actual non-linear deformation of the component carrier structure 100 exceeds the predefined non-linear compensation limit 108, non-linear deformation compensation is carried out in a block 240 only to an extent which does not exceed or which is limited by the predefined non-linear compensation limit 108. Thus, the actually carried out non-linear deformation compensation may be identical to said limit 108, or may be smaller. This can be accomplished for instance as described above referring to Figure 4.

If however the amount of non-linear deformation compensation needed for fully compensating the actual non-linear deformation of the component carrier structure 100 is smaller than or equal to the predefined non-linear compensation limit 108, full non-linear deformation compensation is carried out in a block 250. This can be accomplished for instance as described above referring to Figure 3.

In each of blocks 240 and 250, the non-linear deformation compensation may comprise trapezoidal-based compensation.

As illustrated by block 280, the method may then proceed with aligning and processing the component carrier structure 100 based on alignment information determined in accordance with the described deformation compensation. Thus, aligning and further processing may be carried out after having executed linear deformation compensation according to block 260, complete non-linear deformation compensation according to block 250 or limited or partial non-linear deformation compensation according to block 240.

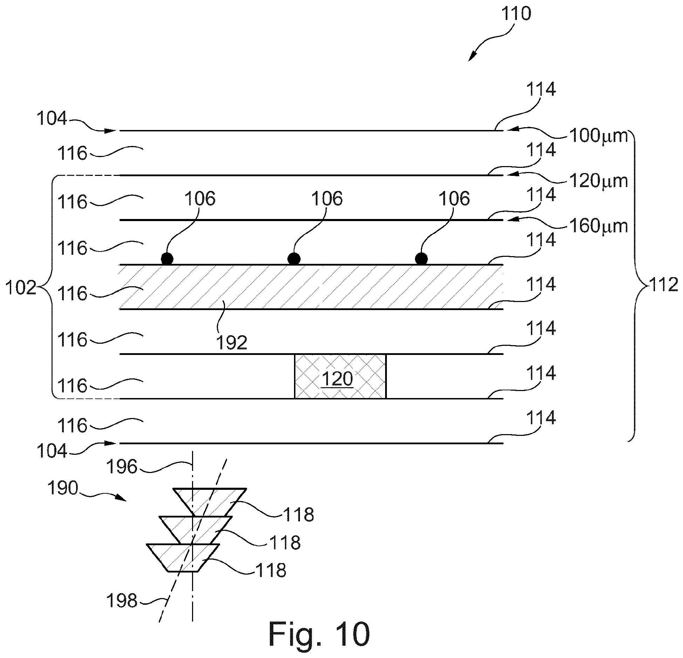

**Figure 10** shows a component carrier 110 manufactured in accordance with a method according to an exemplary embodiment of the invention, as the one illustrated in Figure 9.

As shown, the component carrier 110 can be configured as a laminated stack 112 of electrically conductive layer structures 114 (for instance continuous and/or patterned metal layers such as copper foils, and/or metallic vertical interconnect structures such as copper filled laser vias) and electrically insulating layer structures 116 (for instance comprising resin, in particular epoxy resin, optionally comprising reinforcing particles such as glass fibers or glass spheres; for instance, the electrically insulating material may be prepreg or FR4). The shown component carrier 110 is a plate-shaped laminate-type printed circuit board (PCB) with a core 192. As also shown, a component 120 (such as a semiconductor chip) may be optionally embedded in the stack 112.

A detail 190 also illustrates schematically an array of vertically and laterally displaced vertical interconnect structures 118 forming part of the electrically conductive layer structures 114. Said vertical interconnect structures 118 are connected which each other and are laterally displaced with regard to each other so as to form a laterally and vertically staggered or stepped array of electrically connected vertical interconnect structures 118. The illustrated vertical interconnect structures 118 are laser vias filled with copper. Due to the only limited compensation of non-linear distortions respecting limit 108 during alignment, the vertical interconnect structures 118 shown in Figure 10 show a mutual lateral displacement but are still properly electrically connected with each other. In other words, the arrangement of the interconnect structures 118 according to detail 190 is a fingerprint of the method according to Figure 9, in particular block 240. As shown, centers of gravity of the various vertical interconnect structures 118 may be located substantially on a straight line 198 being slanted with regard to a stacking direction 196 perpendicular to the main surfaces of the layer structures 114, 116.

In the following, a further advantageous embodiment of the method described referring to Figure 9 will be explained referring to Figure 10. As a further refinement of block 240, it is possible that the strict limitation of the compensation of non-linear distortion of the component carrier structure 100 is only applied to outer layers 104 of stack 112, but not to inner layers 102. More specifically, the non-linear deformation compensation in inner layers 102 of the component carrier structure 100 may be carried out fully and even exceeding the predefined non-linear compensation limit 108, but non-linear deformation compensation in exterior layers 104 of the component carrier structure 100 must not exceed the predefined non-linear compensation limit 108. By taking this measure, compliance with user defined boundary conditions on the outer layers 104 being usually most relevant for the further assembly process can be respected, while simultaneously enabling strong or even complete compensation of non-linear distortions in the inner layers 102. For instance in a scenario, in which limit 108 is 100 µm, compliance with this limit 108 is achieved at the upper outer layer 104 in Figure 10 (as indicated by "100 µm"). However, in the following inner layers 102, a non-linear compensation may be carried out for example up to a value of 120 µm and 160 µm, respectively. Thus, the limit 108 may be exceeded in the inner layers 102, but may not be exceeded in the outer layers 104.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

## Claims

1. A method of manufacturing a component carrier (110), wherein the component carrier (110) is a compound of multiple layer structures (114, 116) which are stacked and connected together by applying a pressing force and/or heat to obtain a component carrier (110) with inner layers (102) and exterior layers (104), wherein the exterior layers (104) are processed after the inner layers (102), the method comprising:
predefining (200) a maximum allowed non-linear compensation limit (108) for an inner layer (102) of the component carrier (110) and a maximum allowed non-linear compensation limit (108) for an exterior layer (104) of the component carrier (110), wherein the maximum allowed non-linear compensation limit (108) for an inner layer (102) of the component carrier (110) is larger than the maximum allowed non-linear compensation limit (108) for an exterior layer (104) of the component carrier (110) ;
providing a component carrier structure (100), wherein an inner or an external layer of the component carrier (110) is to be processed;
aligning the component carrier structure (100) to a processing machine; and processing the component carrier structure (100) by the processing machine; wherein aligning the component carrier structure (100) to the processing machine comprises:
detecting one or more alignment markers (106) of the component carrier structure (100) to determine positional information concerning the component carrier structure (100);
determining (230) an actual non-linear deformation of the component carrier structure (100) to be aligned based on a position of the detected one or more alignment markers (106);
determining the non-linear compensation needed for fully compensating the actual non-linear deformation during the processing of the component carrier structure (110) by the processing machine;
if an inner layer (102) of the component carrier (110) is to be processed and if the non-linear compensation needed to fully compensating the actual non-linear deformation is larger than the predefined maximum allowed non-linear compensation limit for an inner layer (102) of the component carrier (110), processing (240) the component carrier structure (100) with the predefined maximum allowed non-linear compensation limit (108) for an inner layer (102) of the component carrier (110);
if an inner layer (102) of the component carrier (110) is to be processed and if the non-linear compensation needed to fully compensating the actual non-linear deformation is not larger than the predefined maximum allowed non-linear compensation limit for an inner layer (102) of the component carrier (110), processing (240) the component carrier structure (100) with the non-linear compensation needed for fully compensating the actual non-linear deformation;
if an exterior layer (104) of the component carrier (110) is to be processed and if the non-linear compensation needed to fully compensating the actual non-linear deformation is larger than the predefined maximum allowed non-linear compensation limit for an exterior layer (104) of the component carrier (110), processing (240) the component carrier structure (100) with the predefined maximum allowed non-linear compensation limit (108) for an exterior layer (104) of the component carrier (110);
if an exterior layer (104) of the component carrier (110) is to be processed and if the non-linear compensation needed to fully compensating the actual non-linear deformation is not larger than the predefined maximum allowed non-linear compensation limit for an exterior layer (104) of the component carrier (110), processing (240) the component carrier structure (100) with the non-linear compensation needed for fully compensating the actual non-linear deformation.

2. The method according to claim 1, wherein the method comprises carrying out the non-linear deformation compensation as a trapezoidal-based compensation or a compensation based on a polygon, in particular an irregular polygon, having at least five corners.

3. The method according to any of claims 1 or 2, wherein the method comprises, if the actual non-linear deformation is zero, carrying out (260) linear deformation compensation, in particular rectangular-based and/or parallelogram-based deformation compensation.

4. The method according to any of claims 1 to 3, wherein the method comprises carrying out full non-linear deformation compensation in one or more inner layers (102) of the component carrier structure (100) even when said full non-linear deformation compensation exceeds the predefined non-linear compensation limit (108), and carrying out non-linear deformation compensation in one or more exterior layers (104) of the component carrier structure (100) without exceeding the predefined non-linear compensation limit (108).

5. The method according to any of claims 1 to 4, wherein the method comprises predefining (200) the non-linear compensation limit (108) by a machine or by a user.

6. The method according to any of claims 1 to 5, wherein the method comprises predefining the non-linear compensation limit (108) as an absolute value of non-linear deformation compensation.

7. The method according to claim 6, wherein the absolute value is in a range between 20 µm and 150 µm.

8. The method according to any of claims 1 to 7, wherein the method comprises predefining the non-linear compensation limit (108) as a ratio between absolute values of a maximum allowed non-linear deformation compensation and an actual non-linear deformation.

9. The method according to claim 8, wherein the ratio is higher at an inner layer than at an outer layer of the component carrier structure (100).

10. The method according to claim 9,
wherein the ratio is decreased continuously from an innermost layer to an outermost layer of the component carrier structure (100).

11. The method according to any of claims 1 to 10, wherein the method comprises partitioning the component carrier structure (100) into a plurality of partitions, and carrying out the aligning individually for the partitions.

12. A computer-readable medium, in which a computer program of aligning a component carrier structure (100) is stored, which computer program, when being executed by one or a plurality of processors (130), is adapted to carry out or control a method according to any of claims 1 to 11.

13. A program element of aligning a component carrier structure (100), which program element, when being executed by one or a plurality of processors (130), is adapted to carry out or control a method according to any of claims 1 to 11.

## Patentansprüche

1. Verfahren zur Herstellung eines Komponententrägers (110), wobei der Komponententräger (110) ein Verbund aus mehreren Schichtstrukturen (114, 116) ist, die gestapelt sind und durch Anwenden einer Druckkraft und/oder Wärme miteinander verbunden werden, um einen Komponententräger (110) mit inneren Schichten (102) und äußeren Schichten (104) zu erhalten, wobei die äußeren Schichten (104) nach den inneren Schichten (102) verarbeitet werden, das Verfahren umfassend:
Vordefinieren (200) einer maximal zulässigen nichtlinearen Kompensationsgrenze (108) für eine innere Schicht (102) des Komponententrägers (110) und einer maximal zulässigen nichtlinearen Kompensationsgrenze (108) für eine äußere Schicht (104) des Komponententrägers (110), wobei die maximal zulässige nichtlineare Kompensationsgrenze (108) für eine innere Schicht (102) des Komponententrägers (110) größer ist als die maximal zulässige nichtlineare Kompensationsgrenze (108) für eine äußere Schicht (104) des Komponententrägers (110) ;
Bereitstellen einer Komponententrägerstruktur (100), wobei eine innere oder eine äußere Schicht des Komponententrägers (110) zu bearbeiten ist;
Ausrichten der Komponententrägerstruktur (100) auf eine Verarbeitungsmaschine; und Verarbeiten der Komponententrägerstruktur (100) durch die Verarbeitungsmaschine; wobei das Ausrichten der Komponententrägerstruktur (100) auf die Verarbeitungsmaschine umfasst:
Erfassen einer oder mehrerer Ausrichtungsmarkierungen (106) der Komponententrägerstruktur (100), um Positionsinformationen bezüglich der Komponententrägerstruktur (100) zu bestimmen;
Bestimmen (230) einer tatsächlichen nichtlinearen Verformung der auszurichtenden Komponententrägerstruktur (100) basierend auf einer Position der erfassten einen oder mehreren Ausrichtungsmarkierungen (106);
Bestimmen der nichtlinearen Kompensation, die zum vollständigen Kompensieren der tatsächlichen nichtlinearen Verformung während der Bearbeitung der Komponententrägerstruktur (110) durch die Verarbeitungsmaschine erforderlich ist;
wenn eine innere Schicht (102) des Komponententrägers (110) zu bearbeiten ist und wenn die nichtlineare Kompensation, die erforderlich ist, um die tatsächliche nichtlineare Verformung vollständig zu kompensieren, größer ist als die vordefinierte maximal zulässige nichtlineare Kompensationsgrenze für eine innere Schicht (102) des Komponententrägers (110), Bearbeiten (240) der Komponententrägerstruktur (100) mit der vordefinierten maximal zulässigen nichtlinearen Kompensationsgrenze (108) für eine innere Schicht (102) des Komponententrägers (110);
wenn eine innere Schicht (102) des Komponententrägers (110) zu bearbeiten ist und wenn die nichtlineare Kompensation, die erforderlich ist, um die tatsächliche nichtlineare Verformung vollständig zu kompensieren, nicht größer ist als die vordefinierte maximal zulässige nichtlineare Kompensationsgrenze für eine innere Schicht (102) des Komponententrägers (110), Bearbeiten (240) der Komponententrägerstruktur (100) mit der nichtlinearen Kompensation, die erforderlich ist, um die tatsächliche nichtlineare Verformung vollständig zu kompensieren;
wenn eine äußere Schicht (104) des Komponententrägers (110) zu bearbeiten ist und wenn die nichtlineare Kompensation, die erforderlich ist, um die tatsächliche nichtlineare Verformung vollständig zu kompensieren, größer ist als die vordefinierte maximal zulässige nichtlineare Kompensationsgrenze für eine äußere Schicht (104) des Komponententrägers (110), Bearbeiten (240) der Komponententrägerstruktur (100) mit der vordefinierten maximal zulässigen nichtlinearen Kompensationsgrenze (108) für eine äußere Schicht (104) des Komponententrägers (110);
wenn eine äußere Schicht (104) des Komponententrägers (110) zu bearbeiten ist und wenn die nichtlineare Kompensation, die erforderlich ist, um die tatsächliche nichtlineare Verformung vollständig zu kompensieren, nicht größer ist als die vordefinierte maximal zulässige nichtlineare Kompensationsgrenze für eine äußere Schicht (104) des Komponententrägers (110), Bearbeiten (240) der Komponententrägerstruktur (100) mit der nichtlinearen Kompensation, die erforderlich ist, um die tatsächliche nichtlineare Verformung vollständig zu kompensieren.

2. Verfahren nach Anspruch 1, wobei das Verfahren ein Durchführen der nichtlinearen Verformungskompensation als trapezbasierte Kompensation oder eine Kompensation basierend auf einem Polygon, insbesondere einem unregelmäßigen Polygon, mit mindestens fünf Ecken umfasst.

3. Verfahren nach einem der Ansprüche 1 oder 2, wobei das Verfahren, wenn die tatsächliche nichtlineare Verformung Null ist, ein Durchführen (260) einer linearen Verformungskompensation, insbesondere einer rechteckbasierten und/oder parallelogrammbasierten Verformungskompensation, umfasst.

4. Verfahren nach einem der Ansprüche 1 bis 3, wobei das Verfahren ein Durchführen einer vollständigen nichtlinearen Verformungskompensation in einer oder mehreren inneren Schichten (102) der Komponententrägerstruktur (100), selbst wenn die vollständige nichtlineare Verformungskompensation die vordefinierte nichtlineare Kompensationsgrenze (108) überschreitet, und ein Durchführen einer nichtlinearen Verformungskompensation in einer oder mehreren äußeren Schichten (104) der Komponententrägerstruktur (100) ohne Überschreiten der vordefinierten nichtlinearen Kompensationsgrenze (108) umfasst.

5. Verfahren nach einem der Ansprüche 1 bis 4, wobei das Verfahren ein Vordefinieren (200) der nichtlinearen Kompensationsgrenze (108) durch eine Maschine oder durch einen Benutzer umfasst.

6. Verfahren nach einem der Ansprüche 1 bis 5, wobei das Verfahren ein Vordefinieren der nichtlinearen Kompensationsgrenze (108) als absoluten Wert der nichtlinearen Verformungskompensation umfasst.

7. Verfahren nach Anspruch 6, wobei der absolute Wert in einem Bereich zwischen 20 µm und 150 µm liegt.

8. Verfahren nach einem der Ansprüche 1 bis 7, wobei das Verfahren ein Vordefinieren der nichtlinearen Kompensationsgrenze (108) als ein Verhältnis zwischen absoluten Werten einer maximal zulässigen nichtlinearen Verformungskompensation und einer tatsächlichen nichtlinearen Verformung umfasst.

9. Verfahren nach Anspruch 8, wobei das Verhältnis an einer inneren Schicht höher ist als an einer äußeren Schicht der Komponententrägerstruktur (100).

10. Verfahren nach Anspruch 9, wobei das Verhältnis von einer innersten Schicht zu einer äußersten Schicht der Komponententrägerstruktur (100) kontinuierlich verringert wird.

11. Verfahren nach einem der Ansprüche 1 bis 10, wobei das Verfahren ein Unterteilen der Komponententrägerstruktur (100) in eine Mehrzahl von Unterteilungen und ein Durchführen eines individuellen Ausrichtens für die Unterteilungen umfasst.

12. Computerlesbares Medium, in dem ein Computerprogramm zum Ausrichten einer Komponententrägerstruktur (100) gespeichert ist, wobei das Computerprogramm, bei Ausführung durch einen oder eine Mehrzahl von Prozessoren (130), zum Ausführen oder Steuern eines Verfahrens nach einem der Ansprüche 1 bis 11 eingerichtet ist.

13. Programmelement zum Ausrichten einer Komponententrägerstruktur (100), wobei das Programmelement, bei Ausführung durch einen oder eine Mehrzahl von Prozessoren (130), zum Ausführen oder Steuern eines Verfahrens nach einem der Ansprüche 1 bis 11 eingerichtet ist.

## Revendications

1. Procédé de fabrication d'un support de composants (110), dans lequel le support de composants (110) est un composé de structures à couches multiples (114, 116) qui sont empilées et connectées ensemble en appliquant une force de pression et/ou de la chaleur pour obtenir un support de composants (110) avec des couches intérieures (102) et des couches extérieures (104), dans lequel les couches extérieures (104) sont traitées après les couches intérieures (102), le procédé comprenant :
la prédéfinition (200) d'une limite maximale de compensation non linéaire autorisée (108) pour une couche intérieure (102) du support de composants (110) et d'une limite maximale de compensation non linéaire autorisée (108) pour une couche extérieure (104) du support de composants (110), dans lequel la limite maximale de compensation non linéaire autorisée (108) pour une couche intérieure (102) du support de composants (110) est supérieure à la limite maximale de compensation non linéaire autorisée (108) pour une couche extérieure (104) du support de composants (110) ;
la fourniture d'une structure de support de composants (100), dans lequel une couche intérieure ou externe du support de composants (110) doit être traitée ;
l'alignement de la structure de support de composants (100) sur une machine de traitement ; et le traitement de la structure de support de composants (100) par la machine de traitement ; dans lequel l'alignement de la structure de support de composants (100) sur la machine de traitement comprend :
la détection d'un ou de plusieurs marqueurs d'alignement (106) de la structure de support de composants (100) pour déterminer des informations de position concernant la structure de support de composants (100) ;
la détermination (230) d'une déformation non linéaire réelle de la structure de support de composants (100) à aligner sur la base d'une position des un ou plusieurs marqueurs d'alignement (106) détectés ;
la détermination de la compensation non linéaire nécessaire pour compenser complètement la déformation non linéaire réelle pendant le traitement de la structure de support de composants (110) par la machine de traitement ;
si une couche intérieure (102) du support de composants (110) doit être traitée et si la compensation non linéaire nécessaire pour compenser complètement la déformation non linéaire réelle est supérieure à la limite maximale de compensation non linéaire autorisée prédéfinie pour une couche intérieure (102) du support de composants (110), le traitement (240) de la structure de support de composants (100) avec la limite maximale de compensation non linéaire autorisée (108) prédéfinie pour une couche intérieure (102) du support de composants (110) ;
si une couche intérieure (102) du support de composants (110) doit être traitée et si la compensation non linéaire nécessaire pour compenser complètement la déformation non linéaire réelle n'est pas supérieure à la limite maximale de compensation non linéaire autorisée prédéfinie pour une couche intérieure (102) du support de composants (110), le traitement (240) de la structure de support de composants (100) avec la compensation non linéaire nécessaire pour compenser complètement la déformation non linéaire réelle ;
si une couche extérieure (104) du support de composants (110) doit être traitée et si la compensation non linéaire nécessaire pour compenser complètement la déformation non linéaire réelle est supérieure à la limite maximale de compensation non linéaire autorisée prédéfinie pour une couche extérieure (104) du support de composants (110), le traitement (240) de la structure de support de composants (100) avec la limite maximale de compensation non linéaire autorisée (108) prédéfinie pour une couche extérieure (104) du support de composants (110) ;
si une couche extérieure (104) du support de composants (110) doit être traitée et si la compensation non linéaire nécessaire pour compenser complètement la déformation non linéaire réelle n'est pas supérieure à la limite maximale de compensation non linéaire autorisée prédéfinie pour une couche extérieure (104) du support de composants (110), le traitement (240) de la structure de support de composants (100) avec la compensation non linéaire nécessaire pour compenser complètement la déformation non linéaire réelle.

2. Procédé selon la revendication 1, dans lequel le procédé comprend la réalisation de la compensation de déformation non linéaire en tant que compensation à base trapézoïdale ou une compensation basée sur un polygone, en particulier un polygone irrégulier, ayant au moins cinq coins.

3. Procédé selon l'une quelconque des revendications 1 ou 2, dans lequel le procédé comprend, si la déformation non linéaire réelle est nulle, la réalisation (260) d'une compensation de déformation linéaire, en particulier une compensation de déformation à base rectangulaire et/ou à base de parallélogramme.

4. Procédé selon l'une quelconque des revendications 1 à 3, dans lequel le procédé comprend la réalisation d'une compensation de déformation non linéaire complète dans une ou plusieurs couches intérieures (102) de la structure de support de composants (100) même lorsque ladite compensation de déformation non linéaire complète dépasse la limite de compensation non linéaire prédéfinie (108), et la réalisation d'une compensation de déformation non linéaire dans une ou plusieurs couches extérieures (104) de la structure de support de composants (100) sans dépasser la limite de compensation non linéaire prédéfinie (108).

5. Procédé selon l'une quelconque des revendications 1 à 4, dans lequel le procédé comprend la prédéfinition (200) de la limite de compensation non linéaire (108) par une machine ou par un utilisateur.

6. Procédé selon l'une quelconque des revendications 1 à 5, dans lequel le procédé comprend la prédéfinition de la limite de compensation non linéaire (108) en tant que valeur absolue de compensation de déformation non linéaire.

7. Procédé selon la revendication 6, dans lequel la valeur absolue est dans une plage entre 20 µm et 150 um.

8. Procédé selon l'une quelconque des revendications 1 à 7, dans lequel le procédé comprend la prédéfinition de la limite de compensation non linéaire (108) en tant que rapport entre des valeurs absolues d'une compensation maximale de déformation non linéaire autorisée et d'une déformation non linéaire réelle.

9. Procédé selon la revendication 8, dans lequel le rapport est plus élevé au niveau d'une couche intérieure qu'au niveau d'une couche extérieure de la structure de support de composants (100).

10. Procédé selon la revendication 9, dans lequel le rapport diminue en continu d'une couche la plus intérieure vers une couche la plus extérieure de la structure de support de composants (100).

11. Procédé selon l'une quelconque des revendications 1 à 10, dans lequel le procédé comprend la division de la structure de support de composants (100) en une pluralité de divisions, et la réalisation de l'alignement individuellement des divisions.

12. Support lisible par ordinateur, dans lequel un programme informatique d'alignement d'une structure de support de composants (100) est stocké, lequel programme informatique, lorsqu'il est exécuté par un ou une pluralité de processeurs (130), est adapté pour réaliser ou commander un procédé selon l'une quelconque des revendications 1 à 11.

13. Élément de programme pour aligner une structure de support de composants (100), lequel élément de programme, lorsqu'il est exécuté par un ou une pluralité de processeurs (130), est adapté pour réaliser ou commander un procédé selon l'une quelconque des revendications 1 à 11.
